(19) Europäisches Patentamt / European Patent Office / Office européen des brevets

(11) **EP 2 650 912 B1**

(12) **EUROPEAN PATENT SPECIFICATION**

(45) Date of publication and mention
of the grant of the patent:
**24.06.2015 Bulletin 2015/26**

(21) Application number: **11847507.8**

(22) Date of filing: **16.11.2011**

(51) Int Cl.:
*B23K 26/60* (2014.01)     *H01L 21/683* (2006.01)
*H01L 21/301* (2006.01)     *C09J 201/00* (2006.01)
*B23K 26/18* (2006.01)     *B23K 26/38* (2014.01)
*B23K 26/40* (2014.01)

(86) International application number:
**PCT/JP2011/076374**

(87) International publication number:
**WO 2012/077471 (14.06.2012 Gazette 2012/24)**

(54) **AUXILIARY SHEET FOR LASER DICING**

HILFSFOLIE FÜR LASERZERTEILUNG

COUCHE AUXILIAIRE POUR DÉCOUPE AU LASER

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **06.12.2010 JP 2010271026**

(43) Date of publication of application:
**16.10.2013 Bulletin 2013/42**

(73) Proprietor: **Kimoto Co., Ltd.
Saitama 338-0013 (JP)**

(72) Inventors:
• **MARUYAMA, Mitsunori
Saitama-shi
Saitama 338-0013 (JP)**

• **ABE, Nobuyuki
Saitama-shi
Saitama 338-0013 (JP)**

(74) Representative: **Strehl Schübel-Hopf & Partner
Maximilianstrasse 54
80538 München (DE)**

(56) References cited:
**JP-A- 2008 091 765     JP-A- 2010 056 329
JP-A- 2010 073 897     US-A1- 2008 160 300
US-A1- 2010 032 087**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 650 912 B1

## Description

### TECHNICAL FIELD

The present invention relates to an auxiliary sheet for laser dicing used preferably for fixing a semiconductor wafer and an optical device wafer, etc. to a substrate when producing semiconductor chips and optical devices, etc. by dividing the substrate of the semiconductor wafer and optical device wafer, etc. into individual pieces by irradiating a laser light.

### BACKGOUND ART

Among substrates of semiconductor devices and optical device wafers, etc., for example, a semiconductor wafer is, after a circuit is formed on a surface thereof, subjected to a backside grinding step for performing grinding processing on a backside of the semiconductor wafer to adjust a thickness of the semiconductor wafer, and a dicing step for dividing the semiconductor wafer into individual pieces having a predetermined chip size. Also, the backside grinding step may be followed by further etching processing, polishing processing or other processing on the backside or processing performed at a high temperature, such as evaporation of a metal film on the backside, may be performed in some cases.

In the dicing step above, normally an auxiliary sheet for dicing is fixed to the semiconductor wafer (patent document 1). By using the auxiliary sheet for dicing in the step above, chipping on the semiconductor chips and scattering of the chips can be prevented as well as damages on the semiconductor wafer can be suppressed. Such an auxiliary sheet for dicing normally has a configuration wherein an acrylic type adhesive agent, etc. is applied to a substrate layer formed of a plastic film, etc. and dried to form an adhesive layer having a thickness of about 1 to 50$\mu$m.

Dicing of a semiconductor wafer is normally performed by using a rotary circular blade, however, in recent years, dicing using a laser light (laser dicing) has been proposed. According to laser dicing, some work which is hard to cut by blade dicing can be cut in some cases, so that it has attracted attentions. A variety of laser dicing sheets used for such laser dicing have been proposed (patent documents 2 to 3).

Further laser dicing sheets are disclosed in JP2010073897 and US2008/160300.

### RELATED ART DOCUMENTS

PATENT DOCUMENTS

Patent Document 1: Japanese Patent Unexamined Publication (Kokai) No. H02-187478
Patent Document 2: Japanese Patent Unexamined Publication (Kokai) No. 2002-343747
Patent Document 3: Japanese Patent Unexamined Publication (Kokai) No. 2005-236082

### SUMMARY OF THE DISCLOSED SUBJECT MATTER

There have been demands for a reduction in size and thickness of semiconductor chips and optical device chips, etc. in recent years. To respond thereto, substrates of semiconductor wafers and optical device wafers, etc. have to be also thinner. When substrates of semiconductor wafers and optical device wafers, etc. are made thinner, it normally results in a decline of the strength. Therefore, to secure that, substrates having higher hardness than before, for example, a sapphire substrate and a substrate obtained by depositing silver on copper have started to be used.

Because these substrates have high hardness as explained above, a dicing capability of a conventionally used laser light is not enough for such substrates. Therefore, to respond thereto, a laser having a short wavelength of 300 to 400nm or so has become in use in recent years.

Such a short-wavelength laser has high energy density and excellent dicing capability, however, for example, in the case of a semiconductor wafer, not only the semiconductor wafer but a dicing auxiliary tape is cut fully in the dicing step and there arose a disadvantage that workability declines in collecting semiconductor chips.

According to the present invention, there is provided an auxiliary sheet for laser dicing as defined in claim 1. The auxiliary sheet of the invention is not cut fully even in a dicing step using a short-wavelength laser and does not deteriorate workability.

The present inventors have found that it is possible to provide an auxiliary sheet for laser dicing having the capabilities as above by the configuration of using a polyolefin film as a substrate and providing specific optical characteristics and attained the present invention.

2

Namely, the auxiliary sheet for laser dicing of the present invention is characterized by comprising a substrate and an adhesive layer provided on one surface of the substrate: wherein the substrate is formed of a polyolefin film, total light transmittance is 50% or higher in a wavelength range of 300 to 400nm, and haze is 70% or higher in a wavelength range of 300 to 400nm.

Also, preferably, the auxiliary sheet for laser dicing of the present invention is characterized in that the substrate is formed of a single layer of a polypropylene film or a polyethylene film, a plurality of layers of polypropylene films or polyethylene films, or a plurality of layers of a polypropylene film and a polyethylene film.

According to the inventions above, since the auxiliary sheet for dicing comprises a substrate and an adhesive layer provided on one surface of the substrate, wherein the substrate is formed of a polyolefin film, total light transmittance is 50% or higher in a wavelength range of 300 to 400nm, and haze is 70% or higher in a wavelength range of 300 to 400nm; it is not cut fully even in a dicing step using a short-wavelength laser and workability is not deteriorated thereby.

## EXEMPLARY MODE FOR CARRYING OUT THE DISLCOSED SUBJECT MATTER

An auxiliary sheet for laser dicing of the present invention is characterized by comprising a substrate and an adhesive layer provided on one surface of the substrate, wherein the substrate is formed of a polyolefin film, total light transmittance is 50% or higher in a wavelength range of 300 to 400nm, and haze is 70% or higher in a wavelength range of 300 to 400nm. Below, processing work of a semiconductor wafer will be taken as an example to explain an embodiment of the respective components.

Note that "total light transmittance" in the present invention indicates a total light transmittance defined by JIS K7375:2008. Also, "haze" indicates a value calculated from a formula below.

$$\text{Haze (\%)} = (\text{diffused light transmittance} / \text{total light transmittance}) \times 100$$

Also, "a total light transmittance in a wavelength range of 300 to 400nm" indicates an average value of those obtained by measuring total light transmittance at an interval of 1nm in the wavelength range of 300 to 400nm. Also, "haze in a wavelength range of 300 to 400nm" indicates an average value of those obtained by measuring haze at an interval of 1nm in the wavelength range of 300 to 400nm.

The auxiliary sheet for laser dicing of the present invention has a total light transmittance of 50% or higher in a wavelength range of 300 to 400nm. As a result of the total light transmittance of 50% or higher in the range above, it is possible to prevent a short-wavelength laser from staying at the auxiliary sheet for laser dicing and to prevent the auxiliary sheet for laser dicing from fracturing. Total light transmittance in the wavelength range of 300 to 400nm is preferably 70% or higher and more preferably 80% or higher.

Also, the auxiliary sheet for laser dicing of the present invention has haze of 70% or higher in a wavelength range of 300 to 400nm. As a result of the haze being 70% or higher, it is possible to diffuse a light when a short-wavelength laser is irradiated to the auxiliary sheet for laser dicing, and it is possible to prevent the auxiliary sheet for laser dicing from fracturing. The haze is preferably 75% or higher and more preferably 80% or higher.

Note that the total light transmittance and haze in the wavelength range of 300 to 400nm defined in the present invention indicate values when irradiating light from the adhesive layer side of the auxiliary sheet for laser dicing of the present invention. However, they may be those satisfying the values above when irradiating a light from the substrate side, as well.

The substrate is formed of a polyolefin film. Since a polyolefin film has high transmittance of a short-wavelength laser of 300 to 400nm or so, by using the polyolefin film as an auxiliary sheet for laser dicing, it is possible to prevent being cut fully even when being irradiated with a short-wavelength laser.

As a polyolefin film, a polyethylene film, polypropylene film, polybutene film, polymethylpentene film, an ethylene-propylene copolymer, ethylene-propylene-butene copolymer and other films may be mentioned. Among them, for being excellent for mass production and being low at laser processability, a polyethylene film and polypropylene film are preferably used and, particularly, a polyethylene film is preferably used.

A pigment may be contained in the polyolefin film so as to satisfy total light transmittance and haze specified in the invention of the present application. As such a pigment, organic resin particles formed of a styrene resin, polyethylene resin, urethane resin, benzoguanamine resin, nylon resin, silicon resin and acrylic resin, etc. and inorganic particles, such as silica, barium sulfate, aluminum hydroxide, magnesium hydroxide, calcium carbonate, magnesium carbonate, calcium silicate, magnesium silicate, titanium oxide, calcium oxide, magnesium oxide, aluminum oxide, zirconium oxide, aluminum nitride, aluminum borate whisker and boron nitride, etc. may be mentioned.

A polyolefin film used as a substrate may be configured by one film (single layer) as explained above or a multilayer structure (multilayer), wherein same kinds of polyolefin films or different kinds of polyolefin films (for example, a polypropylene film and a polyethylene film) are put together.

A thickness of the substrate (an entire thickness when the substrate has a multilayer structure) is preferably 30 to 300$\mu$m and more preferably 50 to 150$\mu$m. When it is 30$\mu$m or thicker, being cut fully by a short-wavelength laser can be prevented more properly. Also, when it is 300$\mu$m or thinner, an expanding property (uniform stretchability in all directions) can be maintained and it is possible to prevent affecting on optical characteristics specified in the present invention. When the thickness of the substrate is in a range of 30 to 300$\mu$m, it is relatively easy to satisfy the total light transmittance and haze specified in the present invention.

As an adhesive layer, an acrylic type pressure sensitive adhesive agent, rubber type pressure sensitive adhesive agent and other pressure sensitive adhesive agents, hot melt adhesive agent and other adhesive agents, thermal compressible thermoplastic resin films, etc. may be used. An adhesive agent, which exhibits pressure sensitive adhesiveness at a normal temperature and exhibits declined adhesiveness by crosslinking and curing when heated or irradiated with ionizing radiation, etc., is preferable for being excellent in fixing a subject to be adhered to in the step (dicing, etc.) and for being easy to remove the subject from the auxiliary sheet for dicing after the step completes.

Also, the adhesive layer may contain organic resin particles or inorganic particles for satisfying the total light transmittance and haze specified in the present invention. As those organic resin particles and inorganic particles, same ones as those mentioned in the polyolefin film above may be used. Note that when the pigment component as above is contained in the adhesive layer, by suppressing a content thereof to approximately 10 parts by weight or less with respect to 100 parts by weight of adhesive component (adhesive agent) of the adhesive layer, it becomes relatively easy to satisfy the total light transmittance and haze specified in the present invention.

A thickness of the adhesive layer is preferably 3 to 50$\mu$m and more preferably 5 to 30$\mu$m. When it is 3$\mu$m or thicker, preferable adhesive force can be maintained as an auxiliary sheet. While when it is 50$\mu$m or thinner, an expanding property can be maintained properly. When the thickness of the adhesive layer is in a range of 5 to 30$\mu$m, it becomes relatively easy to satisfy the total light transmittance and haze specified in the present invention.

Also, the adhesive layer may be also added with a other additives, such as a leveling agent.

To form the adhesive layer as explained above, a method of preparing an application liquid by arbitrarily adding additives and a diluting solvent as needed to materials composing the adhesive layer, applying the application liquid by a conventionally well-known coating method and drying; and a method of melting resin components composing the adhesive layer, adding other necessary components (inorganic pigment, etc.) to be included therein and making a sheet from the resultant; etc. may be mentioned.

According to the auxiliary sheet for laser dicing of the present invention, since it comprises a substrate and an adhesive layer provided on one surface of the substrate, wherein the substrate is formed of a polyolefin film, total light transmittance is 50% or higher in a wavelength range of 300 to 400nm, and haze is 70% or higher in a wavelength range of 300 to 400nm, it is preferably used even in short-wavelength laser processing used on highly hard substrates as it is not cut fully.

The auxiliary sheet for laser dicing of the present invention is used in a manufacture process of semiconductor chips, for example, as below. Namely, the auxiliary sheet for laser dicing of the present invention is adhered to the opposite surface from a surface with semiconductor wafer circuits formed, a laser light is irradiated from the surface with semiconductor wafer circuits, and dividing the semiconductor wafer into individual pieces, one circuit on each piece, so as to manufacture semiconductor chips.

As semiconductor wafers to be applied to the present invention, those having high hardness can be mentioned.

Formation of circuits on the wafer surface is performed by a conventionally well-known method, such as an etching method, lift-off method. The circuits are formed to be a lattice shape on the surface on an inner circumferential portion of the wafer, and there remains an extra portion with no circuit on a range several nm from the outer circumferential edge. A thickness of the wafer before grinding is not particularly limited, but it is normally 500 to 1000$\mu$m or so.

When performing grinding processing on a backside of the semiconductor wafer, a surface protection sheet may be adhered to the circuit surface side to protect the circuits on the surface. The backside grinding processing is to fix the circuit surface side of the wafer with a chuck table, etc. and to grind with a grinder the backside having no circuit formed. When grinding the backside, after grinding the entire backside surface to a predetermined thickness first, only an inner circumferential portion on the backside corresponding to a circuit formation portion (inner circumferential portion) on the surface is ground, and a backside region corresponding to the extra portion, on which circuits are not formed, is left without being ground. As a result, on the semiconductor wafer after grinding, only the inner circumferential portion on the backside is ground to be furthermore thinner and a ring-shaped raised portion is left on the outer circumferential portion. The backside grinding method as above may be performed by a conventionally well-known method. After the backside grinding process, processing of removing a fractured layer generated by grinding may be performed.

Subsequently to the backside grinding step, in accordance with need, etching processing and other processing involving heating, deposition of a metal film on the backside, baking of an organic film or other processing performed at a high temperature may be performed on the backside. Note that when performing processing at a high temperature, the processing on the backside is performed after removing the surface protection sheet.

After the backside grinding step, the auxiliary sheet for laser dicing of the present invention is adhered to the opposite surface side from the surface with circuits on the wafer, and dicing of the wafer is performed. The auxiliary sheet for laser dicing is adhered to the wafer generally by a device called mounter, however, it is not particularly limited to that.

Next, a laser light is irradiated from the semiconductor wafer side of the auxiliary sheet for laser dicing so as to dice the wafer. A short-wavelength laser light having high energy density is used to fully cut a semiconductor wafer having high hardness. As such a short-wavelength laser, for example, a third harmonic (wavelength of 355nm) of a Nd-YAG laser is preferably used. Intensity and illuminance of a laser light may be at a level capable of cutting the wafer fully while it depends on a thickness of the wafer to be cut.

The short-wavelength laser light explained above is irradiated to streets between circuits so as to make chips, one circuit on each chip, out of the wafer. The number of times that the laser light scans one street may be once or more. Preferably, an irradiating position of the laser light and positions of streets between circuits are monitored and the laser light is irradiated while adjusting a position of the laser light.

By using the auxiliary sheet for laser dicing of the present invention having specific optical characteristics, holding a semiconductor wafer from the opposite surface from that with circuits formed thereon, and irradiating a laser light from the circuit surface side of the semiconductor wafer to perform dicing, the semiconductor wafer can be cut fully without cutting the auxiliary sheet for laser dicing fully, so that semiconductor chips can be produced with high workability.

After the dicing finishes, semiconductor chips are picked up from the auxiliary sheet for laser dicing. The pick-up method is not particularly limited and various conventional well-known methods can be used. For example, a method of pushing individual semiconductor chip upward with a needle from the side of the auxiliary sheet for laser dicing and picking up the pushed-up semiconductor chips by using a pick-up device, etc. may be mentioned. Note that when an adhesive layer of the auxiliary sheet for laser dicing is formed of an ultraviolet ray curing adhesive agent, prior to picking up, the adhesive force is lowered by irradiating an ultraviolet ray and, then, the chips are picked up.

The picked up semiconductor chips are subjected to die bonding and resin sealing in normal methods, so that semiconductor devices are produced.

An explanation was made above on an example of using a semiconductor wafer as an adherend, however, the auxiliary sheet for dicing of the present invention is not limited to that and can be also used for dicing semiconductor packages, optical device wafers using sapphire substrates and substrates formed by depositing silver on copper, etc., glass substrates, ceramic substrates, organic material substrates of FPC, etc. and metal materials of elaborate instruments, etc.

**EXAMPLES**

Below, the present invention will be explained further in detail with examples. Note that "part" and "%" are based on weight unless otherwise mentioned.

1. Production of Auxiliary Sheet for Laser Dicing

[Example 1]

On one surface of a polyethylene film having a thickness of $100\mu$m as a substrate, an adhesive layer application liquid prepared from the formula below was applied by a bar coating method and dried to obtain a thickness of $23\mu$m after drying, and an adhesive layer was formed. As a result, an auxiliary sheet for laser dicing of the example 1 was obtained.

< Adhesive Layer Application Liquid in Example 1 >

    * acrylic type pressure sensitive adhesive agent 100 parts
    (COPONYL N4823 by Nippon Synthetic Chemical Industry Co., Ltd.)
    * isocianate compound 0.44 part
    (CORONATE L45E by Nippon Polyurethane Industry Co., Ltd.)
    * diluting solvent 54 parts

[Example 2]

Other than using a polyethylene film having a thickness of $110\mu$m as the substrate, an adhesive layer was formed under the same condition as that in the example 1, and an auxiliary sheet for laser dicing of an example 2 was obtained.

[Example 3]

Other than changing the adhesive layer application liquid in the example 1 to that prepared from the formula below and designing to obtain a thickness of 22μm after drying, an auxiliary sheet for laser dicing of an example 3 was obtained in the same way as in the example 1.

< Adhesive Layer Application Liquid in Example 3 >

    * acrylic type pressure sensitive adhesive agent 100 parts
    (COPONYL N4823 by Nippon Synthetic Chemical Industry Co., Ltd.)
    * isocianate compound 0.44 part
    (CORONATE L45E by Nippon Polyurethane Industry Co., Ltd.)
    * silicon resin particles 4 parts
    (Tospearl 120 by Momentive Performance Materials Inc.)
    * diluting solvent 63 parts

[Example 4]

Other than changing the adhesive layer application liquid in the example 1 to that prepared from the formula below and designing to obtain a thickness of 26μm after drying, an auxiliary sheet for laser dicing of an example 4 was obtained in the same way as in the example 1.

< Adhesive Layer Application Liquid in Example 4 >

    * acrylic type pressure sensitive adhesive agent 100 parts
    (COPONYL N4823 by Nippon Synthetic Chemical Industry Co., Ltd.)
    * isocianate compound 0.44 part
    (CORONATE L45E by Nippon Polyurethane Industry Co., Ltd.)
    * zirconium oxide 4 parts
    (PCS by Nippon Denko Co., Ltd.)
    * diluting solvent 63 parts

[Example 5]

Other than changing the adhesive layer application liquid in the example 1 to that prepared from the formula below, an auxiliary sheet for laser dicing of an example 5 was obtained in the same way as in the example 1.

< Adhesive Layer Application Liquid in Example 5 >

    * acrylic type pressure sensitive adhesive agent 100 parts
    (COPONYL N4823 by Nippon Synthetic Chemical Industry Co., Ltd.)
    * isocianate compound 0.44 part
    (CORONATE L45E by Nippon Polyurethane Industry Co., Ltd.)
    * calcium carbonate 3.27 parts
    (SUN LIGHT SL700 by Takehara Kagaku Kogyo Co., Ltd.)
    * colloidal silica 0.24 part
    (AEROSIL R972 by Nippon Aerosil Co., Ltd.)
    * titanium oxide 0.48 part
    (MULTI-RACK W106 by Toyo Ink MFG Co., Ltd.)

\* diluting solvent 63 parts

[Example 6]

Other than changing to 20 parts of silicon resin particles and 100 parts of diluting solvent, same adhesive layer application liquid as that in the example 3 was prepared. This application liquid was applied to one surface of a substrate, a polypropylene film having a thickness of 100μm, by a bar coating method and dried so as to obtain a thickness of 22μm after drying, and an adhesive layer was formed. As a result, an auxiliary sheet for laser dicing of an example 6 was obtained.

[Comparative Example 1]

Other than changing to 16.36 parts of calcium carbonate, 1.21 parts of colloidal silica, 2.42 parts of titanium oxide and 173 parts of diluting solvent, same adhesive layer application liquid as that in the example 5 was prepared. This application liquid was applied to one surface of a substrate, same polypropylene film as that in the example 6, by a bar coating method and dried so as to obtain a thickness of 25μm after drying, and an adhesive layer was formed. As a result, an auxiliary sheet for laser dicing of a comparative example 1 was obtained.

[Comparative Example 2]

Other than changing to 20 parts of zirconium oxide and 55 parts of diluting solvent, same adhesive layer application liquid as that in the example 4 was prepared. This application liquid was applied to one surface of a substrate, same polypropylene film as that in the example 6, by a bar coating method and dried so as to obtain a thickness of 23μm after drying, and an adhesive layer was formed. As a result, an auxiliary sheet for laser dicing of a comparative example 2 was obtained.

[Comparative Example 3]

Other than using COPONYL N3527 (Nippon Synthetic Chemical Industry Co., Ltd.) as an acrylic type pressure sensitive adhesive agent, same adhesive layer application liquid as that in the example 4 was prepared. This application liquid was applied to one surface of a substrate, a polypropylene film having a thickness of 90μm, by a bar coating method and dried so as to obtain a thickness of 23μm after drying, and an adhesive layer was formed. As a result, an auxiliary sheet for laser dicing of a comparative example 3 was obtained.

2. Evaluation

(1) Total Light Transmittance

As to the auxiliary sheets for laser dicing of the examples 1 to 6 and the comparative examples 1 to 3, total light transmittance (JIS J7375: 2008) was measured in a wavelength range of 300 to 400nm at an interval of 1nm by using a spectral photometer (UV-3101PC: Shimazu Corporation), and an average value thereof was obtained. When measuring, a light was irradiated from the adhesive layer side. The results are shown in Table 1.

(2) Haze Value

As to the auxiliary sheets for laser dicing in the examples 1 to 6 and comparative examples 1 to 3, a diffused light transmittance was measured in a wavelength range of 300 to 400nm at an interval of 1nm by using a spectral photometer (UV-3101PC: Shimazu Corporation). When measuring, a light was irradiated from the adhesive layer side. Next, the total light transmittance at an interval of 1nm in a wavelength range of 300 to 400nm measured in (1) above and the diffused light transmittance were substituted into the haze calculation formula below to obtain haze values, and an average value thereof was obtained. The calculation results are shown in Table 1.

$$\text{Haze (\%) = (diffused light transmittance / total light transmittance)} \times 100$$

(3) Cutting Suitability

Based on the laser irradiation condition below, the auxiliary sheets for laser dicing in the examples 1 to 6 and comparative examples 1 to 3 were irradiated with a laser light from the adhesive layer side of the auxiliary sheets by using a Nd-YAG laser. The results are indicated by "Excellent" for those which cut the substrate by only less than 50μm, "Good" for those which cut the substrate by 50μm or more but less than 80μm, "Acceptable" for those which cut the substrate by 80μm or more but did not cut fully, and "Poor" for those which cut the substrate fully. The results are shown in Table 1.

< Laser Irradiation Condition >

wavelength: 355nm
repetition frequency: 100kHz
average power: 5w
irradiation times: 4 times / 1 line
pulse width: 50ns
converging point: ellipse (long axis of 100μm and short axis of 10μm)
processing feed rate: 100mm/sec.

[Table 1]

|  | Total Light Transmittance (%) | Haze (%) | Cutting Suitability |
| --- | --- | --- | --- |
| Example 1 | 85.5 | 82.1 | Excellent |
| Example 2 | 88.0 | 87.4 | Excellent |
| Example 3 | 71.5 | 91.3 | Excellent |
| Example 4 | 53.3 | 84.7 | Good |
| Example 5 | 55.3 | 88.6 | Good |
| Example 6 | 69.0 | 94.5 | Acceptable |
| Comparative Example 1 | 10.9 | 97.2 | Poor |
| Comparative Example 2 | 25.3 | 98.5 | Poor |
| Comparative Example 3 | 84.5 | 18.8 | Poor |

From the results above, the auxiliary sheets for laser dicing in the examples 1 to 6 comprise a substrate formed of a polyolefin film and an adhesive layer provided on one surface of the substrate, wherein the total light transmittance was 50% or higher in the wavelength range of 300 to 400nm, and the haze was 70% or higher in the wavelength range of 300 to 400nm, consequently, they were not cut fully even when using a short-wavelength laser. Accordingly, according to the auxiliary sheet for laser dicing in the examples 1 to 6, it is known that they are not cut fully even in a dicing step of a semiconductor wafer using a short-wavelength laser and do not deteriorate the workability.
Particularly, since the auxiliary sheets for laser dicing in the examples 1 to 3 exhibited total light transmittance of 70% or higher in the wavelength range of 300 to 400nm and haze of 80% or higher in the wavelength range of 300 to 400nm, the auxiliary sheets for laser dicing had a less chance of being cut and had excellent endurance.
Also, since the auxiliary sheets for laser dicing in the examples 1 to 5 use a polyethylene film as a substrate, they had a less chance of being cut even in a dicing step using a short-wavelength laser and had excellent endurance.
On the other hand, since the auxiliary sheets for laser dicing in the comparative examples 1 and 2 exhibited total light transmittance of lower than 50% in the wavelength range of 300 to 400nm, the short-wavelength laser stayed inside the auxiliary sheets for laser dicing and all of them were cut fully. The auxiliary sheet for laser dicing in the comparative example 3 exhibited total light transmittance of 50% or higher in the wavelength range of 300 to 400nm, however, haze was lower than 70% in the wavelength range of 300 to 400nm. Therefore, when the short-wavelength laser was irradiated on the auxiliary sheet for laser dicing, the light was not be able to be diffused and it was cut fully. Accordingly, according to the auxiliary sheets for laser dicing in the comparative examples 1 to 3, it is known that they result in being poor in workability of collecting semiconductor chips in a dicing step of the semiconductor wafer using a short-wavelength laser.

Next, when irradiating an ultraviolet ray at an irradiance level of 400mj/cm$^2$ from the substrate side of the auxiliary sheet for laser dicing of the example 1, an adhesive force of 20N/25mm before the ultraviolet ray irradiation became 0.6N/25mm after the irradiation, which means the adhesive force declined. Accordingly, it is known that when the auxiliary sheet for laser dicing of the present invention is used in a dicing step, it becomes easy to remove from an adherend and good workability can be obtained.

## Claims

1.   An auxiliary sheet for laser dicing, **characterized by** comprising a substrate and an adhesive layer provided on one surface of the substrate, wherein:

the substrate is formed of a polyolefin film;
the total light transmittance is 50% or higher, said total light transmittance being obtained in accordance with JIS K7375:2008 and being the average value of total light transmittance in the wavelength range of 300 to 400nm measured at an interval of 1nm; and
the average value of haze in the wavelength range of 300 to 400nm measured at an interval of 1nm is 70% or higher.

2.   The auxiliary sheet for laser dicing according to claim 1, **characterized in that** the substrate is formed of a single layer of a polypropylene film or a polyethylene film, a plurality of layers of polypropylene films or polyethylene films, or a plurality of layers of a polypropylene film and a polyethylene film.

3.   The auxiliary sheet for laser dicing according to claim 1, **characterized in that** the adhesive layer includes an adhesive agent which exhibits pressure sensitive adhesiveness at normal temperature and exhibits declined adhesiveness as a result of cross-linking and curing by being heated or irradiated with ionizing radiation.

## Patentansprüche

1.   Hilfsfolie für die Laserzerteilung, **gekennzeichnet durch** ein Substrat und eine auf einer Fläche des Substrats vorgesehene Klebeschicht, wobei
das Substrat aus einem Polyolefinfilm gebildet ist,
die Gesamtlicht-Transmission mindestens 50% beträgt, wobei die Gesamtlicht-Transmission gemäß JIS K7375:2008 erhalten wird und der bei einem Messintervall von 1 nm gemessene Durchschnittswert der Gesamtlicht-Transmission in dem Wellenlängenbereich von 300 bis 400 nm ist,
der mit einem Messintervall von 1 nm gemessene Durchschnittswert der Trübung in dem Wellenlängenbereich von 300 bis 400 nm mindestens 70% beträgt.

2.   Hilfsfolie für die Laserzerteilung gemäß Anspruch 1, **dadurch gekennzeichnet, dass** das Substrat aus einer einzigen Schicht eines Polypropylenfilms oder eines Polyethylenfilms, mehreren Schichten von Polypropylenfilmen oder Polyethylenfilmen, oder mehreren Schichten eines Polypropylenfilms und eines Polyethylenfilms gebildet ist.

3.   Hilfsfolie für die Laserzerteilung gemäß Anspruch 1, **dadurch gekennzeichnet, dass** die Klebeschicht einen Klebstoff aufweist, der eine drucksensitive Klebefähigkeit bei normaler Temperatur und eine abnehmende Klebefähigkeit als Ergebnis einer Vernetzung und Aushärtung zeigt, wenn er erwärmt oder mit ionisierender Strahlung bestrahlt wird.

## Revendications

1.   Feuille auxiliaire pour découpe au laser, **caractérisée en ce qu'**elle comprend un substrat et une couche adhésive prévue sur une surface du substrat, dans laquelle :

le substrat est formé d'un film de polyoléfine,
le facteur de transmission lumineuse totale est de 50% ou plus, ledit facteur de transmission lumineuse totale étant obtenu conformément à JIS K7375:2008 et étant la valeur moyenne du facteur de transmission lumineuse totale dans la plage de longueur d'onde de 300 à 400nm mesurée selon un intervalle de 1nm, et

la valeur moyenne de trouble dans la plage de longueur d'onde de 300 à 400nm mesurée selon un intervalle de 1nm est de 70% ou plus.

2. Feuille auxiliaire pour découpe au laser selon la revendication 1, **caractérisé en ce que** le substrat est formé d'une seule couche d'un film de polypropylène ou d'un film de polyéthylène, d'une pluralité de couches de films de polypropylène ou de films de polyéthylène, ou d'une pluralité de couches d'un film de polypropylène et d'un film de polyéthylène.

3. Feuille auxiliaire pour découpe au laser selon la revendication 1, **caractérisée en ce que**
la couche d'adhésif comprend un agent adhésif qui présente une adhésivité sensible à la pression à une température normale et présente une adhésivité réduite en raison de la réticulation et du durcissement par chauffage ou irradiation avec un rayonnement ionisant.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010073897 B
- US 2008160300 A
- JP H02187478 B
- JP 2002343747 A
- JP 2005236082 A